# EUROPEAN PATENT APPLICATION

(11) **EP 3 757 678 A1**
(43) Date of publication of application: **30.12.2020**
(21) Application number: 19794058.8
(22) Date of filing: 26.04.2019
(51) Int. Cl.: G03F 7/11, G03F 7/20, G03F 7/26

(54) **RESIST UNDERLAYER FILM FORMING COMPOSITION AND METHOD FOR FORMING PATTERN**

(30) Priority: 27.04.2018 JP 2018086440
(71) Applicant: MITSUBISHI GAS CHEMICAL COMPANY, INC., Chiyoda-ku Tokyo 100-8324 (JP)
(72) Inventor: SATO, Takashi, Hiratsuka-shi, Kanagawa 254-0016 (JP); ECHIGO, Masatoshi, Tokyo 100-8324 (JP); MAKINOSHIMA, Takashi, Hiratsuka-shi, Kanagawa 254-0016 (JP)
(74) Representative: Müller-Boré & Partner Patentanwälte PartG mbB
(86) International application number: PCT/JP2019/017903
(87) International publication number: WO 2019/208761

(57) **Abstract**

A composition for resist underlayer film formation, containing a compound represented by the following formula (1).

[LₓTe(OR¹)_{y}] (1)

(In the above formula (1), L is a ligand other than OR¹; R¹ is any of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms and a substituted or unsubstituted alkenyl group having 2 to 20 carbon atoms; x is an integer of 0 to 6; y is an integer of 0 to 6; the total of x and y is 1 to 6; when x is 2 or more, a plurality of L may be the same or different; and when y is 2 or more, a plurality of R¹ may be the same or different.)

## Description

### Technical Field

The present invention relates to a composition for resist underlayer film formation and a pattern formation method.

### Background Art

In the production of semiconductor devices, fine processing is practiced by lithography using photoresist materials. In recent years, further miniaturization based on pattern rules has been demanded along with increase in the integration and speed of large scale integrated circuits (LSI). Lithography technology using light exposure, which is currently used as a general purpose technique, is approaching the limit of essential resolution derived from the wavelength of a light source.

The light source for lithography used upon forming resist patterns has been shifted to ArF excimer laser (193 nm) having a shorter wavelength from KrF excimer laser (248 nm). However, as the miniaturization of resist patterns proceeds, the problem of resolution or the problem of collapse of resist patterns after development arises. From such a background, in recent years, resists have been desired to have a thinner film. However, it is difficult to obtain a sufficient film thicknesses of the resist pattern when processing the substrate simply by only thinning the resist. Therefore, there has been a need for a process of preparing a resist underlayer film between a resist and a semiconductor substrate to be processed, and imparting functions as a mask for substrate processing to this resist underlayer film in addition to a resist pattern.

Various resist underlayer films used for the above process are currently known. For example, in order to obtain a resist underlayer film for lithography having the selectivity of a dry etching rate close to that of resists, unlike conventional resist underlayer films having a fast dry etching rate, an underlayer film forming material for a multilayer resist process containing a resin component having a substituent that generates a sulfonic acid residue by eliminating a terminal group under application of predetermined energy, and a solvent has been disclosed in Patent Document 1. Also, in order to obtain a resist underlayer film for lithography having the selectivity of a dry etching rate smaller than that of resists, a resist underlayer film material containing a polymer having a specific repeat unit has been disclosed in Patent Document 2. Furthermore, in order to obtain a resist underlayer film for lithography having the selectivity of a dry etching rate smaller than that of semiconductor substrates, a resist underlayer film material containing a polymer prepared by copolymerizing a repeat unit of an acenaphthylene and a repeat unit having a substituted or unsubstituted hydroxy group has been disclosed in Patent Document 3.

Meanwhile, as a resist underlayer film having high etching resistance, amorphous carbon underlayer films formed by chemical vapor deposition (CVD) using methane gas, ethane gas, acetylene gas, or the like as a raw material are well known. As a material for amorphous carbon underlayer films, materials that can form resist underlayer films by a wet process such as spin coating or screen printing have been demanded from the viewpoint of a process.

In addition, as a resist underlayer film forming material for lithography that is not only excellent in a optical property and an etching resistance, but also is soluble in a solvent and applicable to a wet process, Patent Documents 4 and 5 disclose materials containing a naphthalene formaldehyde polymer containing a particular structural unit and an organic solvent.

Furthermore, as a method for forming an intermediate layer used in the formation of a resist underlayer film in a three-layer process, Patent Document 6 discloses a method for forming a silicon nitride film and Patent Document 7 discloses a CVD formation method for a silicon nitride film. As an intermediate layer material for a three-layer process, materials containing a silsesquioxane-based silicon compound have been disclosed in Patent Documents 8 and 9.

### Citation List

### Patent Document

Patent Document 1: Japanese Patent Application Laid-Open No. 2004-177668
Patent Document 2: Japanese Patent Application Laid-Open No. 2004-271838
Patent Document 3: Japanese Patent Application Laid-Open No. 2005-250434
Patent Document 4: International Publication No. WO 2009/072465
Patent Document 5: International Publication No. WO 2011/034062
Patent Document 6: Japanese Patent Application Laid-Open No. 2002-334869
Patent Document 7: International Publication No. WO 2004/066377
Patent Document 8: Japanese Patent Application Laid-Open No. 2007-226170
Patent Document 9: Japanese Patent Application Laid-Open No. 2007-226204

### Summary of Invention

### Technical Problem

When a composition for resist underlayer film formation is used in a wet process such as spin coating or screen printing, the components used in the composition for resist underlayer film formation are required to have high solvent solubility applicable to the wet process. Therefore, the compositions for resist underlayer film formation described in Patent Documents 1 to 5 are desired to have high solvent solubility applicable to a wet process such as spin coating or screen printing, and have excellent etching resistance.

Also, in recent years, as the miniaturization of patterns proceeds, it has been required that even the steps of an uneven substrate (particularly having fine space, hole pattern, etc.) can be uniformly and completely filled. By providing a resist underlayer to be arranged on the substrate side, it has been required to obtain a good resist pattern with enhanced flatness.

Thus, an object of the present invention is, in order to solve the above problems, to provide a composition for resist underlayer film formation that is applicable to a wet process, excellent in etching resistance, and can provide a good resist pattern when used as a resist underlayer film, as well as a pattern formation method.

### Solution to Problem

The inventors have, as a result of devoted examinations to solve the above problems, found out that the above problems can be solved by using a compound having a particular structure for a composition for resist underlayer films, and reached the present invention.

More specifically, the present invention is as follows.
[1] A composition for resist underlayer film formation, comprising a compound represented by the following formula (1).

   [LₓTe(OR¹)_{y}] (1)

   (In the above formula (1), L is a ligand other than OR¹; R¹ is any of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms and a substituted or unsubstituted alkynyl group having 2 to 20 carbon atoms; x is an integer of 0 to 6; y is an integer of 0 to 6; the total of x and y is 1 to 6; when x is 2 or more, a plurality of L may be the same or different; and when y is 2 or more, a plurality of R¹ may be the same or different.)
[2] The composition for resist underlayer film formation according to [1], wherein, in the compound represented by the above formula (1), x is an integer of 1 to 6.
[3] The composition for resist underlayer film formation according to [1] or [2], wherein, in the compound represented by the above formula (1), y is an integer of 1 to 6.
[4] The composition for resist underlayer film formation according to any of [1] to [3], wherein, in the compound represented by the above formula (1), R¹ is a substituted or unsubstituted, linear alkyl group having 1 to 6 carbon atoms or branched or cyclic alkyl group having 3 to 6 carbon atoms.
[5] The composition for resist underlayer film formation according to any of [1] to [4], wherein, in the compound represented by the above formula (1), L is a bi- or higher-dentate ligand.
[6] The composition for resist underlayer film formation according to any of [1] to [5], wherein, in the compound represented by the above formula (1), L is any of acetylacetonato, 2,2-dimethyl-3,5-hexanedione, ethylenediamine, diethylenetriamine and methacrylic acid.
[7] The composition for resist underlayer film formation according to any of [1] to [6], further comprising a solvent.
[8] The composition for resist underlayer film formation according to any of [1] to [7], further comprising an acid generating agent.
[9] The composition for resist underlayer film formation according to any of [1] to [8], further comprising an acid crosslinking agent.
[10] The composition for resist underlayer film formation according to any of [1] to [9], further comprising an acid diffusion controlling agent.
[11] The composition for resist underlayer film formation according to any of [1] to [10], further comprising a polymerization initiator.
[12] A method for forming a pattern, comprising the steps of:
   forming a resist underlayer film on a substrate using the composition for resist underlayer film formation according to any of [1] to [11];
   forming at least one photoresist layer on the resist underlayer film; and
   irradiating a predetermined region of the photoresist layer with radiation for development.
[13] A method for forming a pattern, comprising the steps of:
   forming a resist underlayer film on a substrate using the composition for resist underlayer film formation according to any of [1] to [11];
   forming a resist intermediate layer film on the resist underlayer film using a resist intermediate layer film material;
   forming at least one photoresist layer on the resist intermediate layer film;
   irradiating a predetermined region of the photoresist layer with radiation for development, thereby forming a resist pattern;
   etching the resist intermediate layer film with the resist pattern as an etching mask, thereby forming an intermediate layer film pattern;
   etching the resist underlayer film with the intermediate layer film pattern as an etching mask, thereby forming an underlayer film pattern; and
   etching the substrate with the underlayer film pattern as an etching mask, thereby forming a pattern on the substrate.

### Advantageous Effects of Invention

According to the present invention, a composition for resist underlayer film formation that is applicable to a wet process, excellent in etching resistance, and can provide a good resist pattern when used as a resist underlayer film, as well as a pattern formation method, can be provided.

### Description of Embodiments

Hereinafter, an embodiment of the present invention will be described (hereinafter, referred to as the "present embodiment"). Note that the present embodiment is given in order to illustrate the present invention. The present invention is not limited to the present embodiment.

### [Composition for resist underlayer film formation]

A composition for resist underlayer film formation of the present embodiment (hereinafter, also simply referred to as the "composition") contains a compound represented by the formula (1), which will be mentioned later (hereinafter, also referred to as the "tellurium containing compound"). The composition of the present embodiment is applicable to a wet process since the tellurium containing compound is excellent in solubility in a safe solvent. Since the composition for resist underlayer film formation of the present embodiment contains the tellurium containing compound, deterioration of the film upon baking is suppressed and a resist underlayer film excellent in etching resistance to fluorine gas-based plasma etching or the like can be formed. Since the composition for resist underlayer film formation of the present embodiment contains the tellurium containing compound, a resist underlayer film formed from such a composition has excellent adhesiveness to the resist layer, thereby forming an excellent resist pattern. Since the composition of the present embodiment contains the tellurium containing compound, it is excellent in heat resistance, etching resistance, step embedding properties and flatness, and thus it is used as a composition that forms the undermost layer of the resist layer constituted with a plurality of layers.

Note that the resist layer containing a resist underlayer film formed by using the composition of the present embodiment may further contain another resist underlayer film between the substrate and the resist underlayer film described above. Here, the "underlayer film" refers to a film constituting all or a part of the layer in the resist layer, formed between the substrate and the photoresist layer.

### <Tellurium containing compound>

The tellurium containing compound in the present embodiment is a compound represented by the following formula (1).

[LₓTe(OR¹)_{y}] (1)

In the formula (1), L is a ligand other than OR¹; R¹ is any of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms and a substituted or unsubstituted alkynyl group having 2 to 20 carbon atoms; x is an integer of 0 to 6; y is an integer of 0 to 6; the total of x and y is 1 to 6; when x is 2 or more, a plurality of L may be the same or different; and when y is 2 or more, a plurality of R¹ may be the same or different.

Examples of R¹ include any of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms and a substituted or unsubstituted alkynyl group having 2 to 20 carbon atoms. When there is a plurality of R¹, they may be the same as or different from each other.

Specific examples of R¹ include, for example, a methyl group, an ethyl group, a propyl group, a butyl group, a pentyl group, a hexyl group, a heptyl group, an octyl group, a nonyl group, a decyl group, an undecyl group, a dodecyl group, an icosyl group, a cyclopropyl group, a cyclobutyl group, a cyclopentyl group, a cyclohexyl group, a cycloheptyl group, a cyclooctyl group, a cyclononyl group, a cyclodecyl group, a cycloundecyl group, a cyclododecyl group, a cycloicosyl group, a norbornyl group, an adamantyl group, a phenyl group, a naphthyl group, an anthracene group, a pyrenyl group, a biphenyl group, a heptacene group, a vinyl group, a propenyl group, a butenyl group, a pentenyl group, a hexenyl group, an ethynyl group, a proallyl group, an icosynyl group and a pargyl group. These groups follow a concept of encompassing isomers, and for example, a butyl group is not limited to a n-butyl group, and may be an isobutyl group, a sec-butyl group or a tert-butyl group. In addition, these groups may have a substituent as long as the number of carbon atoms does not exceed 20, and examples of the substituent include a functional group selected from the group consisting of a carboxyl group, an acryl group and a methacryl group, as well as groups containing these groups.

Among them, from the viewpoint of etching resistance and solubility, R¹ is preferably a substituted or unsubstituted, linear alkyl group having 1 to 6 carbon atoms or branched or cyclic alkyl group having 3 to 6 carbon atoms, and is more preferably a linear alkyl group having 1 to 4 carbon atoms or branched or cyclic alkyl group having 3 to 4 carbon atoms. When it has a substituent, that substituent is preferably one or more selected from the group consisting of a carboxyl group, a group containing carboxyl group, an acrylate group and a methacrylate group, and is more preferably one or more selected from the group consisting of an acrylate group and a methacrylate group.

L is a ligand other than OR¹, and may be a monodentate ligand or a multidentate ligand, i.e., a bi- or higher-dentate ligand. When there is a plurality of L, they may be the same as or different from each other.

Specific examples of the monodentate ligand include acrylate, methacrylate, amine, chloro, cyano, thiocyano, isothiocyano, nitro, nitrito, triphenylphosphine, pyridine and cyclopentene. Specific examples of the multidentate ligand include, for example, ethylenediamine, acetylacetonato, 2,2-dimethyl-3,5-hexanedione, diethylenetriamine, acrylic acid, methacrylic acid and ethylenediaminetetraacetic acid.

From the viewpoint of flatness, L is preferably a multidentate ligand, i.e., a bi- or higher-dentate ligand, is more preferably any of acetylacetonato, 2,2-dimethyl-3,5-hexanedione, ethylenediamine, diethylenetriamine and methacrylic acid, and is still more preferably any of acetylacetonato, 2,2-dimethyl-3,5-hexanedione and methacrylic acid.

x is an integer of 0 to 6, y is an integer of 0 to 6, and x + y is 1 to 6. From the viewpoint of solubility in a safe solvent, x is preferably an integer of 1 to 6, is more preferably an integer of 1 to 4, and is still more preferably 1 or 2. From the viewpoint of heat resistance, y is preferably an integer of 1 to 6, is more preferably an integer of 1 to 4, and is still more preferably an integer of 2 to 4.

The tellurium containing compound is preferably a compound represented by the following formula (1-1), the following formula (1-2) or the following formula (1-3).

[Te(OR¹)₄] (1-1)

(In the formula (1-1), R¹ is as defined in the formula (1).) 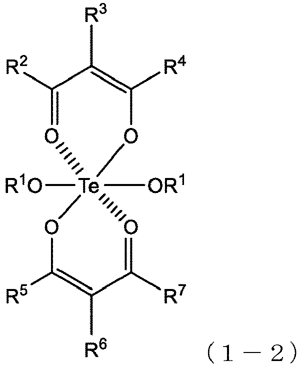 (In the formula (1-2), R¹ is as defined in the formula (1) ; and R², R³, R⁴, R⁵, R⁶ and R⁷ may be the same or different, and are each independently a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, or a substituted or unsubstituted alkynyl group having 2 to 20 carbon atoms.) 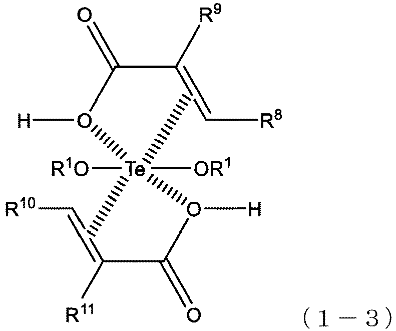 (In the formula (1-3), R¹ is as defined in the formula (1); R⁹ and R¹¹ may be the same or different, and are each independently a hydrogen atom or a methyl group; and R⁸ and R¹⁰ may be the same or different, and are each independently a hydrogen atom, a substituted or unsubstituted linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms, or a substituted or unsubstituted alkynyl group having 2 to 20 carbon atoms.)

Although the tellurium containing compound in the present embodiment is not particularly limited, examples thereof include the following compounds. Among them, a compound represented by the formula (TOX-1), the formula (TOX-2), the formula (TOX-3) or the formula (TOX-4) is preferable.

Te(OEt)₄ (TOX-1)

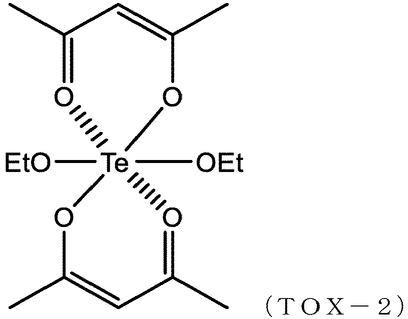

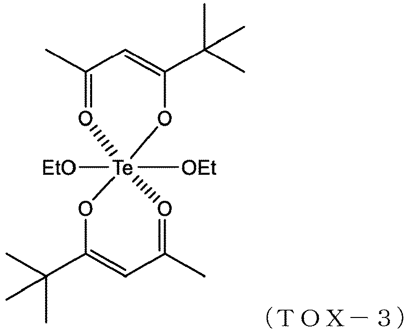

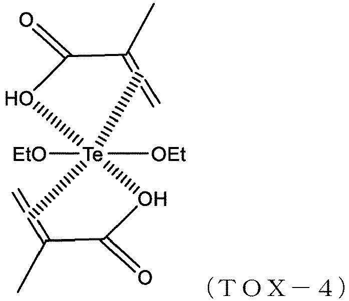

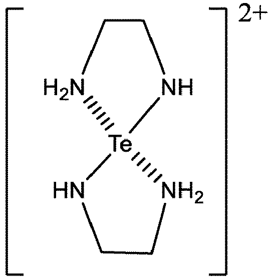

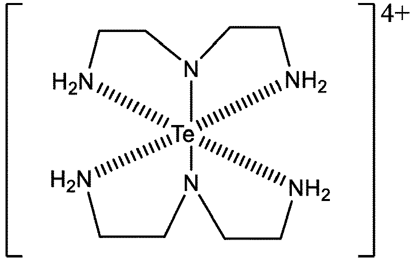

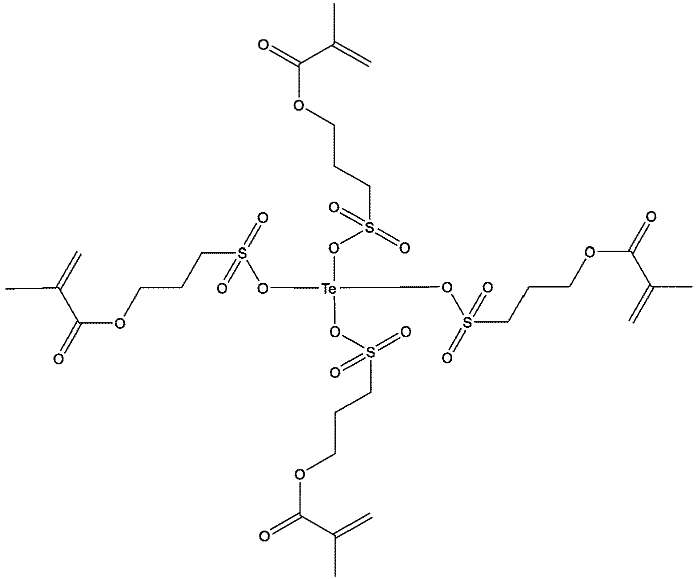

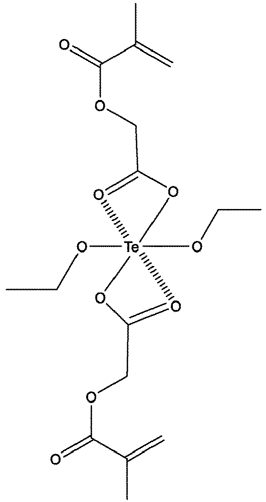

### (Method for producing tellurium containing compound)

The tellurium containing compound according to the present embodiment is obtained by, for example, the following method. That is, by heating metal tellurium or tellurium dioxide in a chlorine gas stream to about 500°C, tellurium tetrachloride is obtained. Next, by allowing the obtained tellurium tetrachloride to react with sodium alkoxide under ice cooling with no catalyst, an alkoxy tellurium compound, wherein x is 0 and y is 1 or more in the formula (1), can be obtained. For example, a compound represented by the formula (TOX-1) mentioned above (tetraethoxytellurium(IV)) can be obtained by allowing tellurium tetrachloride to react with ethanol. Alternatively, the tellurium containing compound can be obtained through electrolysis using metal tellurium as the positive electrode.

In the present embodiment, L, which is a ligand other than OR¹, can be obtained by a variety of methods. For example, a tellurium containing compound to which L is coordinated can be obtained by mixing and stirring an alkoxy tellurium compound or metal tellurium dissolved in an organic solvent such as tetrahydrofuran and a ligand L dissolved in an organic solvent such as tetrahydrofuran, and removing the organic solvent. A specific example is shown below. That is, when tetraethoxytellurium(IV) (a compound represented by the formula (TOX-1) mentioned above) is used as an alkoxy tellurium compound, by placing 1.0 g of tetraethoxytellurium(IV) dissolved in 20 mL of tetrahydrofuran in a container with an inner volume of 100 mL equipped with a stirrer, a condenser tube and a burette, further adding 0.5 g of acetylacetone dissolved in 5 mL of tetrahydrofuran, allowing the resultant mixture to reflux for 1 hour, and removing the solvent under reduced pressure, a compound represented by the formula (TOX-2) mentioned above can be obtained.

Besides, for example, by stirring an aqueous solution of sodium tellurite and a carboxylic acid, a tellurium compound to which carboxylate is coordinated is readily produced.

### (Method for purifying tellurium containing compound)

The tellurium containing compound of the present embodiment can be purified by, for example, a purification method including the following steps. The purification method includes a step of dissolving the tellurium containing compound in a solvent containing an organic solvent that does not inadvertently mix with water to obtain a solution (A), and a step of bringing the obtained solution (A) into contact with an acidic aqueous solution, thereby extracting impurities in the tellurium containing compound (a first extraction step). According to the purification method of the present embodiment, the contents of various metals that may be contained as impurities in the tellurium containing compound having a specific structure mentioned above can be reduced effectively.

The tellurium containing compound used in the purification method of the present embodiment may be one kind, or may be a mixture of two or more kinds.

The "organic solvent that does not inadvertently mix with water" used in the purification method of the present embodiment means an organic solvent that is not uniformly mixed with water at an arbitrary ratio. Although such an organic solvent is not particularly limited, it is preferably an organic solvent that is safely applicable to semiconductor production processes. Specifically, it is an organic solvent having a solubility in water at room temperature of less than 30%, more preferably is an organic solvent having a solubility of less than 20%, and particularly preferably is an organic solvent having solubility of less than 10%. It is preferable that the amount of the organic solvent to be used is 1 to 100 parts by mass based on 100 parts by mass of the tellurium containing compound to be used.

Specific examples of the solvent that does not inadvertently mix with water include, but are not limited to, for example, an ether such as diethyl ether and diisopropyl ether; an ester such as ethyl acetate, n-butyl acetate and isoamyl acetate; a ketone such as methyl ethyl ketone, methyl isobutyl ketone, ethyl isobutyl ketone, cyclohexanone (CHN), cyclopentanone, 2-heptanone and 2-pentanone; a glycol ether acetate such as ethylene glycol monoethyl ether acetate, ethylene glycol monobutyl ether acetate, propylene glycol monomethyl ether acetate (PGMEA) and propylene glycol monoethyl ether acetate; an aliphatic hydrocarbon such as n-hexane and n-heptane; an aromatic hydrocarbon such as toluene and xylene; and a halogenated hydrocarbon such as methylene chloride and chloroform. Among the above, one or more organic solvents selected from the group consisting of toluene, 2-heptanone, cyclohexanone, cyclopentanone, methyl isobutyl ketone, propylene glycol monomethyl ether acetate, ethyl acetate and the like are preferable, methyl isobutyl ketone, ethyl acetate, cyclohexanone and propylene glycol monomethyl ether acetate are more preferable, and methyl isobutyl ketone and ethyl acetate are still more preferable. Methyl isobutyl ketone, ethyl acetate and the like have relatively high saturation solubility for the tellurium containing compound and a relatively low boiling point, and it is thus possible to reduce the load in the case of industrially distilling off the solvent and in the step of removing the solvent by drying. These organic solvents can be each used alone, and can also be used as a mixture of two or more kinds.

The "acidic aqueous solution" used in the purification method of the present embodiment is arbitrarily selected from among aqueous solutions in which organic compounds or inorganic compounds are dissolved in water, generally known as acidic aqueous solutions. Examples of the acidic aqueous solution include, but are not limited to, for example, an aqueous mineral acid solution in which a mineral acid, such as hydrochloric acid, sulfuric acid, nitric acid and phosphoric acid, is dissolved in water; and an aqueous organic acid solution in which an organic acid, such as acetic acid, propionic acid, oxalic acid, malonic acid, succinic acid, fumaric acid, maleic acid, tartaric acid, citric acid, methanesulfonic acid, phenolsulfonic acid, p-toluenesulfonic acid and trifluoroacetic acid, is dissolved in water. These acidic aqueous solutions can be each used alone, and can also be used as a combination of two or more kinds. Among these acidic aqueous solutions, aqueous solutions of one or more mineral acids selected from the group consisting of hydrochloric acid, sulfuric acid, nitric acid and phosphoric acid, or aqueous solutions of one or more organic acids selected from the group consisting of acetic acid, propionic acid, oxalic acid, malonic acid, succinic acid, fumaric acid, maleic acid, tartaric acid, citric acid, methanesulfonic acid, phenolsulfonic acid, p-toluenesulfonic acid and trifluoroacetic acid are preferable, aqueous solutions of sulfuric acid, nitric acid, and carboxylic acids such as acetic acid, oxalic acid, tartaric acid and citric acid are more preferable, aqueous solutions of sulfuric acid, oxalic acid, tartaric acid and citric acid are still more preferable, and an aqueous solution of oxalic acid is even more preferable. It is considered that polyvalent carboxylic acids such as oxalic acid, tartaric acid and citric acid coordinate with metal ions and provide a chelating effect, and thus tend to be capable of more effectively removing metals. Also, as for water used herein, it is preferable to use water, the metal content of which is small, such as ion exchanged water, according to the purpose of the purification method of the present embodiment.

The pH of the acidic aqueous solution to be used in the purification method of the present embodiment is not particularly limited, but it is preferable to regulate the acidity of the aqueous solution in consideration of an influence on the tellurium containing compound. Normally, the pH range of the acidic aqueous solution is about 0 to 5, and is preferably about pH 0 to 3.

The amount of the acidic aqueous solution to be used in the purification method of the present embodiment is not particularly limited, but it is preferable to regulate the amount to be used from the viewpoint of reducing the number of extraction operations for removing metals and from the viewpoint of ensuring operability in consideration of the overall amount of fluid. From the above viewpoints, the amount of the acidic aqueous solution to be used is preferably 10 to 200% by mass, and more preferably 20 to 100% by mass, based on 100% by mass of the solution (A).

In the purification method of the present embodiment, by bringing an acidic aqueous solution as described above into contact with the solution (A) containing one or more selected from the tellurium containing compounds mentioned above and the organic solvent that does not inadvertently mix with water, metals can be extracted from the compounds in the solution (A).

When the solution (A) contains an organic solvent that inadvertently mixes with water, there is a tendency that the amount of the tellurium containing compound to be charged can be increased, also the fluid separability is improved, and purification can be carried out at a high reaction vessel efficiency. The method for adding the organic solvent that inadvertently mixes with water is not particularly limited. For example, any of a method involving adding it to the organic solvent containing solution in advance, a method involving adding it to water or the acidic aqueous solution in advance, and a method involving adding it after bringing the organic solvent containing solution into contact with water or the acidic aqueous solution may be employed. Among the above, the method involving adding it to the organic solvent containing solution in advance is preferable in terms of the workability of operations and the ease of managing the amount to be charged.

The organic solvent that inadvertently mixes with water to be used in the purification method of the present embodiment is not particularly limited, but is preferably an organic solvent that is safely applicable to semiconductor production processes. The amount of the organic solvent that inadvertently mixes with water to be used is not particularly limited as long as the solution phase and the aqueous phase separate, but is preferably 0.1 to 100 parts by mass, more preferably 0.1 to 50 parts by mass, and still more preferably 0.1 to 20 parts by mass based on 100 parts by mass of the tellurium containing compound.

Specific examples of the organic solvent that inadvertently mixes with water to be used in the purification method of the present embodiment include, but are not limited to, an ether such as tetrahydrofuran and 1,3-dioxolane; an alcohol such as methanol, ethanol and isopropanol; a ketone such as acetone and N-methylpyrrolidone; and an aliphatic hydrocarbon such as a glycol ether such as ethylene glycol monoethyl ether, ethylene glycol monobutyl ether, propylene glycol monomethyl ether (PGME) and propylene glycol monoethyl ether. Among the above, N-methylpyrrolidone, propylene glycol monomethyl ether and the like are preferable, and N-methylpyrrolidone and propylene glycol monomethyl ether are more preferable. These solvents can be each used alone, and can also be used as a mixture of two or more kinds.

In the purification method of the present embodiment, the temperature when the solution (A) and the acidic aqueous solution are brought into contact, that is, when extraction treatment is carried out, is preferably in the range of 20 to 90°C, and more preferably 30 to 80°C. The extraction operation is not particularly limited, and is carried out by, for example, thoroughly mixing the solution (A) and the acidic aqueous solution by stirring or the like and then leaving the obtained mixed solution to stand still. Thereby, metals contained in the solution (A) containing one or more selected from the tellurium containing compounds and the organic solvents are transferred to the aqueous phase. Also, by this operation, the acidity of the solution (A) is lowered, and the deterioration of the tellurium containing compound can be suppressed.

By leaving the mixed solution to stand still, it is separated into an aqueous phase and a solution phase containing one or more selected from the tellurium containing compounds and the organic solvents, and thus the solution phase containing one or more selected from the tellurium containing compounds and the organic solvents can be recovered by decantation or the like. The time for leaving the mixed solution to stand still is not particularly limited, but it is preferable to regulate the time for leaving the mixed solution to stand still from the viewpoint of attaining better separation of the solution phase containing the organic solvents and the aqueous phase. Normally, the time for leaving the mixed solution to stand still is 1 minute or longer, preferably 10 minutes or longer, and still more preferably 30 minutes or longer. While the extraction treatment may be carried out only 1 time, it is also effective to repeat mixing, leaving-to-stand-still, and separating operations multiple times.

It is preferable that the purification method of the present embodiment includes a step of further bringing the solution phase containing the compound into contact with water after the first extraction step, thereby extracting impurities in the compound (a second extraction step). Specifically, for example, it is preferable that, after the extraction treatment is carried out using an acidic aqueous solution, the solution phase that is extracted and recovered from the aqueous solution and that contains one or more selected from the tellurium containing compounds and the organic solvents is further subjected to extraction treatment with water. The extraction treatment with water is not particularly limited, and can be carried out by, for example, thoroughly mixing the solution phase and water by stirring or the like and then leaving the obtained mixed solution to stand still. The mixed solution after being left to stand still is separated into an aqueous phase and a solution phase containing one or more selected from the tellurium containing compounds and the organic solvents, and thus the solution phase containing one or more selected from the tellurium containing compounds and the organic solvents can be recovered by decantation or the like. Also, water used herein is preferably water, the metal content of which is small, such as ion exchanged water, according to the purpose of the present embodiment. While the extraction treatment may be carried out only once, it is also effective to repeat mixing, leaving-to-stand-still, and separating operations multiple times. In addition, the proportions of both used in the extraction treatment, and temperature, time and other conditions are not particularly limited, and may be the same as those of the previous contact treatment with the acidic aqueous solution.

Water that is possibly present in the thus obtained solution containing one or more selected from the tellurium containing compounds and the organic solvents can be readily removed by performing vacuum distillation or a like operation. Also, if required, the concentration of the tellurium containing compound can be regulated to be any concentration by adding an organic solvent to the solution.

The method for isolating the one or more selected from the tellurium containing compounds from the obtained solution containing one or more selected from the tellurium containing compounds and the organic solvents is not particularly limited, and publicly known methods can be carried out, such as reduced-pressure removal, separation by reprecipitation, and a combination thereof. A publicly known treatment such as concentration operation, filtration operation, centrifugation operation and drying operation can be carried out, if required.

The composition of the present embodiment may further contain one or more selected from the group consisting of a solvent, an acid crosslinking agent, an acid generating agent, an acid diffusion controlling agent and a basic compound as arbitrary components.

The content of the tellurium containing compound in the composition of the present embodiment is preferably 0.1 to 100% by mass, more preferably 0.5 to 50% by mass, still more preferably 3.0 to 50% by mass, even more preferably 10 to 50% by mass, and yet even more preferably 20 to 50% by mass based on 100% by mass of the solid content of the composition for resist underlayer film formation, from the viewpoint of coatability and quality stability.

The content of the tellurium containing compound in the composition of the present embodiment is preferably 0.1 to 30% by mass, more preferably 0.5 to 15% by mass, and still more preferably 1.0 to 10% by mass based on the entire mass of the composition for resist underlayer film formation, from the viewpoint of coatability and quality stability.

### <Solvent>

Since the composition of the present embodiment is excellent in solubility in a safe solvent, it can contain a solvent (in particular, a safe solvent). The safe solvent used herein refers to a solvent that has low toxicity to the human body. Examples of the safe solvent include, for example, cyclohexanone (CHN), propylene glycol monomethyl ether (PGME), propylene glycol monomethyl ether acetate (PGMEA), ethyl lactate (EL) and methyl hydroxyisobutyrate (HBM).

It is preferable that the composition (for example, composition for resist) of the present embodiment contains a solvent. Examples of the solvent can include, but are not particularly limited to, for example, an ethylene glycol monoalkyl ether acetate such as ethylene glycol monomethyl ether acetate, ethylene glycol monoethyl ether acetate, ethylene glycol mono-n-propyl ether acetate and ethylene glycol mono-n-butyl ether acetate; an ethylene glycol monoalkyl ether such as ethylene glycol monomethyl ether and ethylene glycol monoethyl ether; a propylene glycol monoalkyl ether acetate such as propylene glycol monomethyl ether acetate (PGMEA), propylene glycol monoethyl ether acetate, propylene glycol mono-n-propyl ether acetate and propylene glycol mono-n-butyl ether acetate; a propylene glycol monoalkyl ether such as propylene glycol monomethyl ether (PGME) and propylene glycol monoethyl ether; a lactate ester such as methyl lactate, ethyl lactate, n-propyl lactate, n-butyl lactate and n-amyl lactate; an aliphatic carboxylic acid ester such as methyl acetate, ethyl acetate, n-propyl acetate, n-butyl acetate, n-amyl acetate, n-hexyl acetate, methyl propionate and ethyl propionate; another ester such as methyl 3-methoxypropionate, ethyl 3-methoxypropionate, methyl 3-ethoxypropionate, ethyl 3-ethoxypropionate, methyl 3-methoxy-2-methylpropionate, 3-methoxybutyl acetate, 3-methyl-3-methoxybutyl acetate, butyl 3-methoxy-3-methylpropionate, butyl 3-methoxy-3-methylbutyrate, methyl acetoacetate, methyl pyruvate and ethyl pyruvate; an aromatic hydrocarbon such as toluene and xylene; a ketone such as 2-heptanone, 3-heptanone, 4-heptanone, cyclopentanone (CPN) and cyclohexanone (CHN); an amide such as N,N-dimethylformamide, N-methylacetamide, N,N-dimethylacetamide and N-methylpyrrolidone; and a lactone such as γ-lactone. These solvents can be used alone as one kind, or can be used in combination of two or more kinds.

Among the above solvents, from the viewpoint of safety, one or more selected from the group consisting of cyclohexanone, propylene glycol monomethyl ether, propylene glycol monomethyl ether acetate, ethyl lactate, methyl hydroxyisobutyrate and anisole are preferable.

The content of the solvent is not particularly limited and is preferably 100 to 10,000 parts by mass, more preferably 200 to 5,000 parts by mass, and still more preferably 200 to 1,000 parts by mass based on 100 parts by mass of the entire solid content of the composition for resist underlayer film formation, from the viewpoint of solubility and film formability.

### <Acid crosslinking agent>

It is preferable that the composition of the present embodiment contains an acid crosslinking agent from the viewpoint of, for example, suppressing intermixing. Examples of the acid crosslinking agent include, for example, a melamine compound, an epoxy compound, a guanamine compound, a glycoluril compound, a urea compound, a thioepoxy compound, an isocyanate compound, an azide compound, and a compound having a double bond such as an alkenyl ether group, and these compounds may have at least one group selected from the group consisting of a methylol group, an alkoxymethyl group and an acyloxymethyl group as a substituent (crosslinkable group). Note that these acid crosslinking agents are used alone as one kind or used in combination of two or more kinds.

Specific examples of the acid crosslinking agent include, for example, the compounds described as acid crosslinking agents in International Publication No. WO 2013/024779.

In the composition of the present embodiment, the content of the acid crosslinking agent is not particularly limited and is preferably 0.1 to 50 parts by mass, and more preferably 1 to 40 parts by mass based on 100 parts by mass of the entire solid content of the composition for resist underlayer film formation. By setting the content of the acid crosslinking agent to the preferable range mentioned above, a mixing event with a resist layer tends to be prevented. Also, an antireflection effect is enhanced, and film formability after crosslinking tends to be enhanced.

### <Acid generating agent>

It is preferable that the composition of the present embodiment contains an acid generating agent from the viewpoint of further accelerating crosslinking reaction by heat. The acid generating agent may be a compound that generates an acid by thermal decomposition, or may be a compound that generates an acid by light irradiation.

As the acid generating agent, for example, the compounds described as acid generating agents in International Publication No. WO 2013/024779 are used.

In the composition of the present embodiment, the content of the acid generating agent is not particularly limited and is preferably 0.1 to 50 parts by mass, and more preferably 0.5 to 40 parts by mass based on 100 parts by mass of the entire solid content of the composition for resist underlayer film formation. By setting the content of the acid generating agent to the above range, crosslinking reaction tends to be enhanced by an increased amount of an acid to be generated. Also, a mixing event with a resist layer tends to be prevented.

### <Acid diffusion controlling agent>

It is preferable that the composition of the present embodiment contains an acid diffusion controlling agent from the viewpoint of controlling diffusion of the acid generated from the acid generating agent by radiation irradiation in a resist film to inhibit any unpreferable chemical reaction in an unexposed region. When the acid diffusion controlling agent is contained in the composition of the present embodiment, there is a tendency that the storage stability of such a composition is improved even more. In addition, along with even further improvement in the resolution, the line width change of a resist pattern due to variation in the post exposure delay time before radiation irradiation and the post exposure delay time after radiation irradiation can be inhibited even more, and the composition tends to have even more excellent process stability.

The acid diffusion controlling agent contains, for example, a radiation degradable basic compound such as a nitrogen atom containing basic compound, a basic sulfonium compound and a basic iodonium compound. More specifically, examples of the radiation degradable basic compound include the compounds described in paragraphs 0128 to 0141 of International Publication No. WO 2013/024778. These radiation degradable basic compounds can be used alone as one kind, or can be used in combination of two or more kinds.

The content of the acid diffusion controlling agent in the composition of the present embodiment is preferably 0.1 to 50 parts by mass, and more preferably 0.5 to 40 parts by mass based on 100 parts by mass of the solid content. When the content is within the above range, the chemical reaction tends to proceed properly.

### <Dissolution controlling agent>

The composition of the present embodiment may contain a dissolution controlling agent. The dissolution controlling agent is a component having a function of, when the solubility of the tellurium containing compound in a developing solution is too high, controlling the solubility of the compound to moderately decrease the dissolution rate upon developing. As such a dissolution controlling agent, the one which does not chemically change in steps such as calcination, heating and development of optical component is preferable.

The dissolution controlling agent is not particularly limited, and examples thereof can include, for example, an aromatic hydrocarbon such as phenanthrene, anthracene and acenaphthene; a ketone such as acetophenone, benzophenone and phenyl naphthyl ketone; and a sulfone such as methyl phenyl sulfone, diphenyl sulfone and dinaphthyl sulfone. These dissolution controlling agents can be used alone, or can be used in combination of two or more kinds.

The content of the dissolution controlling agent is not particularly limited, and is arbitrarily adjusted depending on the type of the tellurium containing compound to be used. However, it is preferably 0 to 49% by mass of the entire mass of the solid components, and particularly preferably 0% by mass. When the composition contains the dissolution controlling agent, the content thereof is more preferably 0.1 to 5% by mass, and still more preferably 0.5 to 1% by mass.

### <Sensitizing agent>

The composition of the present embodiment may contain a sensitizing agent. The sensitizing agent is a component having a function of absorbing irradiated radiation energy, transmitting the energy to the acid generating agent (C), and thereby increasing the acid production amount, and improving the apparent curability of the resist underlayer film forming composition. Such a sensitizing agent is not particularly limited, and examples thereof can include a benzophenone, a biacetyl, a pyrene, a phenothiazine and a fluorene. These sensitizing agents can be used alone, or can be used in combination of two or more kinds. The content of the sensitizing agent, which is arbitrarily adjusted depending on the type of the tellurium containing compound to be used, is preferably 0 to 49% by mass of the entire mass of the solid components, and particularly preferably 0% by mass. When the composition contains the sensitizing agent, the content thereof is more preferably 0.1 to 5% by mass, and still more preferably 0.5 to 1% by mass.

### <Polymerization initiator>

It is preferable that the composition of the present embodiment contains a polymerization initiator from the viewpoint of improving the curability. The polymerization initiator is not limited as long as it initiates, by exposure, the polymerization reaction of the tellurium containing compound described above and one or more components selected from resins, which will be mentioned later, and a publicly known polymerization initiator can be contained. Examples of the polymerization initiator can include, but are not limited to, a photoradical polymerization initiator, a photocationic polymerization initiator and a photoanionic polymerization initiator, and from the viewpoint of reactivity, a photoradical polymerization initiator is preferable.

Examples of the photoradical polymerization initiator can include, but are not limited to, an alkylphenone-based photoradical polymerization initiator, an acylphosphine oxide-based photoradical polymerization initiator and an oxyphenylacetic acid ester-based photoradical polymerization initiator. From the viewpoint of reactivity, an alkylphenone-based photoradical polymerization initiator is preferable, and from the viewpoint of easy availability, 1-hydroxycyclohexyl phenyl ketone (trade name: IRGACURE 184 manufactured by BASF SE), 2,2-dimethoxy-2-phenylacetophenone (trade name: IRGACURE 651 manufactured by BASF SE) and 2-hydroxy-2-methyl-1-phenylpropanone (trade name: IRGACURE 1173 manufactured by BASF SE) are preferable.

In the composition of the present embodiment, the content of the polymerization initiator is preferably 0.1 to 20 parts by mass, more preferably 0.3 to 20 parts by mass, and still more preferably 0.5 to 10 parts by mass based on 100 parts by mass of the entire mass of the tellurium containing compound and the resin.

### <Basic compound>

The composition of the present embodiment may further contain a basic compound from the viewpoint of, for example, improving the storage stability.

The basic compound plays a role as a quencher against an acid in order to prevent crosslinking reaction from proceeding due to a trace amount of an acid generated by the acid generating agent. Examples of such a basic compound include, for example, a primary, secondary or tertiary aliphatic amine, an amine blend, an aromatic amine, a heterocyclic amine, a nitrogen containing compound having a carboxyl group, a nitrogen containing compound having a sulfonyl group, a nitrogen containing compound having a hydroxy group, a nitrogen containing compound having a hydroxyphenyl group, an alcoholic nitrogen containing compound, an amide derivative and an imide derivative. Specific examples of the basic compound include, for example, the compounds described as basic compounds in International Publication No. WO 2013/024779.

In the composition of the present embodiment, the content of the basic compound is not particularly limited and is preferably 0.001 to 2 parts by mass, and more preferably 0.01 to 1 part by mass based on 100 parts by mass of the entire solid content of the composition for resist underlayer film formation. By setting the content of the basic compound to the preferable range mentioned above, the storage stability tends to be enhanced without excessively deteriorating crosslinking reaction.

### <Resin>

The composition of the present embodiment may contain, in addition to the tellurium containing compound described above, a resin to be used as a material for resist underlayer film formation such as a material for lithography (in particular, a resist material) for the purpose of conferring thermosetting properties or controlling absorbance. The "resin" as used herein refers to a film forming component excluding the tellurium containing compound, a solvent, which will be mentioned later, the acid generating agent, the acid crosslinking agent, the acid diffusion controlling agent, the polymerization initiator and the further component, and follows a concept of also encompassing low molecular weight compounds.

Such a resin is not particularly limited, and examples thereof include a naphthol resin, a xylene resin naphthol-modified resin, a phenol-modified resin obtained by modifying a naphthalene resin with a phenol (for example, phenol, naphthol and the like), a modified resin obtained by modifying a naphthalene formaldehyde resin with a phenol (for example, phenol, naphthol and the like), a polyhydroxystyrene, a dicyclopentadiene resin, a novolac resin, a resin containing (meth)acrylate, dimethacrylate, trimethacrylate, tetramethacrylate, a naphthalene ring such as vinylnaphthalene or polyacenaphthylene, a biphenyl ring such as phenanthrenequinone or fluorene, or a heterocyclic ring having a heteroatom such as thiophene or indene, and a resin containing no aromatic ring; and a resin or a compound containing an alicyclic structure, such as a rosin-based resin, a cyclodextrin, an adamantine(poly)ol, a tricyclodecane(poly)ol, and a derivative thereof. Among the above, from the viewpoint of achieving the action effects of the present invention more effectively and reliably, the resin is preferably at least one selected from the group consisting of a naphthol resin, a modified resin obtained by modifying a xylene formaldehyde resin with naphthol and a modified resin obtained by modifying a naphthalene formaldehyde resin with phenol, and is more preferably a modified resin obtained by modifying a naphthalene formaldehyde resin with phenol.

The number average molecular weight (Mn) of the resin is preferably 300 to 3,5000, preferably 300 to 3,000, and still more preferably 500 to 2,000.

The weight average molecular weight (Mw) of the resin is preferably 500 to 20,000, more preferably 800 to 10,000, and still more preferably 1,000 to 8,000.

The dispersity (Mw/Mn) of the resin is preferably 1.0 to 5.0, more preferably 1.2 to 4.0, and still more preferably 1.5 to 3.0.

The number average molecular weight (Mn), weight average molecular weight (Mw) and dispersity (Mw/Mn) mentioned above can be determined in terms of polystyrene by gel permeation chromatography (GPC) analysis. More specifically, measurement methods for the above are according to the methods described in Examples.

The content of the resin is not particularly limited, and is preferably 1000 parts by mass or less, more preferably 500 parts by mass or less, still more preferably 200 parts by mass or less, and particularly preferably 100 parts by mass based on 100 parts by mass of the total amount of the tellurium containing compound of the present embodiment. In addition, when the resin is contained, the content of the resin is not particularly limited, and is preferably 10 parts by mass or more, more preferably 30 parts by mass or more, still more preferably 50 parts by mass or more, and particularly preferably 80 parts by mass or more based on 100 parts by mass of the total amount of the tellurium containing compound of the present embodiment.

The composition for resist underlayer film formation of the present embodiment may further contain a publicly known additive agent. Examples of the above publicly known additive agent include, but are not limited to, for example, a curing catalyst, an ultraviolet absorber, a surfactant, a colorant and a nonionic surfactant.

### [Resist underlayer film for lithography]

A resist underlayer film for lithography of the present embodiment (hereinafter, also referred to as the "resist underlayer film") is formed from the composition for resist underlayer film formation of the present embodiment. The resist underlayer film for lithography of the present embodiment can be formed by a method, which will be mentioned later.

### [Pattern formation method]

A pattern formed by a pattern formation method of the present embodiment, which will be mentioned later, is used as a resist pattern or a circuit pattern, for example.

A first pattern formation method of the present embodiment has the steps of: forming a resist underlayer film on a substrate using the composition of the present embodiment (step (A-1)); forming at least one photoresist layer on the resist underlayer film (step (A-2)); and after forming at least one photoresist layer in the step (A-2), irradiating a predetermined region of the photoresist layer with radiation for development (step (A-3)). Note that the "photoresist layer" means the outermost layer of the resist layer, that is, the layer provided on the most front side (the side opposite to the substrate) of the resist layer.

Furthermore, a second pattern formation method of the present embodiment has the steps of: forming a resist underlayer film on a substrate using the composition of the present embodiment (step (B-1)); forming a resist intermediate layer film on the resist underlayer film using a resist intermediate layer film material (for example, a silicon containing resist layer) (step (B-2)); forming at least one photoresist layer on the resist intermediate layer film (step (B-3)); irradiating a predetermined region of the photoresist layer with radiation for development, thereby forming a resist pattern (step (B-4)); etching the resist intermediate layer film with the resist pattern as an etching mask, thereby forming an intermediate layer film pattern (step (B-5)); etching the resist underlayer film with the intermediate layer film pattern as an etching mask, thereby forming an underlayer film pattern (step (B-6)); and etching the substrate with the underlayer film pattern as an etching mask, thereby forming a pattern on the substrate (step (B-7)).

The resist underlayer film of the present embodiment is not particularly limited by its formation method as long as it is formed from the composition of the present embodiment. A publicly known approach can be applied thereto. The resist underlayer film can be formed by, for example, applying the composition of the present embodiment onto a substrate by a publicly known coating method or printing method such as spin coating or screen printing, and then removing a solvent by volatilization or the like.

It is preferable to perform baking treatment in the formation of the resist underlayer film, for preventing the occurrence of a mixing event with an upper layer resist (for example, the photoresist layer or resist intermediate layer film) while accelerating crosslinking reaction. In this case, the baking temperature is not particularly limited and is preferably in the range of 80 to 450°C, and more preferably 200 to 400°C. The baking time is not particularly limited, either, and it is preferably in the range of 10 seconds to 300 seconds. Note that the thickness of the resist underlayer film can be arbitrarily selected according to required performance and is not particularly limited, but is usually preferably about 30 to 20,000 nm, and more preferably 50 to 15,000 nm.

After preparing the resist underlayer film on the substrate, a resist intermediate layer film can be provided between the photoresist layer and the resist underlayer film. For example, in the case of a two-layer process, a silicon containing resist layer or a usual single-layer resist made of hydrocarbon can be provided on the resist underlayer film, as the resist intermediate layer film. Also, in the case of a three-layer process, for example, it is preferable to prepare a silicon containing intermediate layer between the resist intermediate layer film and the photoresist layer, and to further prepare a silicon-free single-layer resist layer thereon. As a photoresist material for forming the photoresist layer, resist intermediate layer film and resist layer provided between these layers, those publicly known can be used.

For example, as the silicon containing resist material for a two-layer process, a silicon atom containing polymer such as a polysilsesquioxane derivative or a vinylsilane derivative is used as a base polymer, and a positive type photoresist material further containing an organic solvent, an acid generating agent, and if required, a basic compound or the like is preferably used, from the viewpoint of oxygen gas etching resistance. Here, a publicly known polymer that is used in this kind of resist material can be used as the silicon atom containing polymer.

In addition, a polysilsesquioxane-based intermediate layer is preferably used as the silicon containing intermediate layer for a three-layer process, for example. By imparting effects as an antireflection film to the resist intermediate layer film, there is a tendency that reflection can be effectively suppressed. For example, use of a material containing a large amount of an aromatic group and having high substrate etching resistance as the resist underlayer film in a process for exposure at 193 nm tends to increase a k value and enhance substrate reflection. However, the resist intermediate layer film suppresses the reflection so that the substrate reflection can be 0.5% or less. The intermediate layer having such an antireflection effect is not limited, and polysilsesquioxane that crosslinks by an acid or heat in which a light absorbing group having a phenyl group or a silicon-silicon bond is introduced is preferably used for exposure at 193 nm.

Alternatively, a resist intermediate layer film formed by chemical vapor deposition (CVD) may be used. The intermediate layer highly effective as an antireflection film prepared by CVD is not limited, and, for example, a SiON film is known. In general, the formation of a resist intermediate layer film by a wet process such as spin coating or screen printing is more convenient and more advantageous in cost, as compared with CVD. The upper layer resist for a three-layer process may be positive type or negative type, and the same as a single-layer resist generally used can be used.

The resist underlayer film of the present embodiment can also be used as an antireflection film for usual single-layer resists or an underlying material for suppression of pattern collapse. The resist underlayer film of the present embodiment is excellent in etching resistance for an underlying process and can be expected to also function as a hard mask for an underlying process.

In the case of forming a resist layer from the publicly known photoresist material mentioned above, a wet process such as spin coating or screen printing is preferably used, as in the case of forming the above resist underlayer film. Also, after coating with the resist material by spin coating or the like, prebaking is generally performed. This prebaking is preferably performed at a baking temperature of 80 to 180°C and for a baking time in the range of 10 seconds to 300 seconds. Then, exposure, post-exposure baking (PEB), and development can be performed according to a conventional method to obtain a resist pattern. Note that the thickness of each resist film is not particularly limited, and in general, is preferably 30 nm to 500 nm and more preferably 50 nm to 400 nm.

In addition, the exposure light can be arbitrarily selected and used according to the photoresist material to be used. General examples thereof can include a high energy ray having a wavelength of 300 nm or less, specifically, excimer laser of 248 nm, 193 nm, or 157 nm, soft x-ray of 3 to 20 nm, electron beam, and X-ray.

In a resist pattern formed by the method mentioned above, pattern collapse is suppressed by the resist underlayer film of the present embodiment. Therefore, use of the resist underlayer film of the present embodiment can produce a finer pattern and can reduce an exposure amount necessary for obtaining the resist pattern.

Next, etching is performed with the obtained resist pattern as a mask. Gas etching is preferably used as the etching of the resist underlayer film in a two-layer process. The gas etching is suitably etching using oxygen gas. In addition to oxygen gas, an inert gas such as He or Ar, or CO, CO₂, NH₃, SO₂, N₂, NO₂, or H₂ gas may be added. Alternatively, the gas etching may be performed only with CO, CO₂, NH₃, N₂, NO₂, or H₂ gas without the use of oxygen gas. Particularly, the latter gas is preferably used for side wall protection in order to prevent the undercut of pattern side walls.

On the other hand, gas etching is also preferably used as the etching of the intermediate layer (layer positioned between the photoresist layer and the resist underlayer film) in a three-layer process. The same gas etching as described in the two-layer process mentioned above is applicable. Particularly, it is preferable to process the intermediate layer in a three-layer process by using chlorofluorocarbon-based gas and using the resist pattern as a mask. Then, as mentioned above, for example, the resist underlayer film can be processed by oxygen gas etching with the intermediate layer pattern as a mask.

Here, in the case of forming an inorganic hard mask intermediate layer film as the intermediate layer, a silicon oxide film, a silicon nitride film, or a silicon oxynitride film (SiON film) is formed by CVD, ALD, or the like. A method for forming the nitride film is not limited, and, for example, a method described in Japanese Patent Application Laid-Open No. 2002-334869 or WO 2004/066377 can be used. Although a photoresist film can be formed directly on such an intermediate layer film, an organic antireflection film (BARC) may be formed on the intermediate layer film by spin coating and a photoresist film may be formed thereon.

A polysilsesquioxane-based intermediate layer is preferably used as the intermediate layer. By imparting effects as an antireflection film to the resist intermediate film, there is a tendency that reflection can be effectively suppressed. A specific material for the polysilsesquioxane-based intermediate layer is not limited, and, for example, a material described in Japanese Patent Application Laid-Open No. 2007-226170 or Japanese Patent Application Laid-Open No. 2007-226204 can be used.

The etching of the substrate can also be performed by a conventional method. For example, the substrate made of SiO₂ or SiN can be etched mainly using chlorofluorocarbon-based gas, and the substrate made of p-Si, Al, or W can be etched mainly using chlorine- or bromine-based gas. In the case of etching the substrate with chlorofluorocarbon-based gas, the silicon containing resist of the two-layer resist process or the silicon containing intermediate layer of the three-layer process is peeled at the same time with substrate processing. On the other hand, in the case of etching the substrate with chlorine- or bromine-based gas, the silicon containing resist layer or the silicon containing intermediate layer is separately peeled and in general, peeled by dry etching using chlorofluorocarbon-based gas after substrate processing.

The resist underlayer film of the present embodiment is excellent in etching resistance of these substrates. Note that the substrate can be arbitrarily selected for use from publicly known ones and is not particularly limited. Examples thereof include Si, α-Si, p-Si, SiO₂, SiN, SiON, W, TiN, and Al. The substrate may be a laminate having a film to be processed (substrate to be processed) on a base material (support). Examples of such a film to be processed include various low-k films such as Si, SiO₂, SiON, SiN, p-Si, α-Si, W, W-Si, Al, Cu, and Al-Si, and stopper films thereof. A material different from that for the base material (support) is generally used. Note that the thickness of the substrate to be processed or the film to be processed is not particularly limited and is generally preferably about 50 nm to 10,000 nm, and more preferably 75 nm to 5,000 nm.

The resist underlayer film of the present embodiment is excellent in embedding flatness to a substrate having difference in level. As a method for evaluating the embedding flatness, a publicly known method can be arbitrarily selected for use and is not particularly limited. For example, the embedding flatness to a substrate having difference in level can be evaluated by: coating a silicon substrate having difference in level with a solution of each compound, the concentration of which has been adjusted to a predetermined value, by spin coating; removing the solvent and drying at 110°C for 90 seconds to form a tellurium containing underlayer film such that the film has a predetermined thickness; then baking at a temperature of about 240 to 300°C for a predetermined time; and then measuring the difference in the thickness of the underlayer film (ΔT) between the line and space region and the open region with no pattern, using an ellipsometer.

### Examples

Hereinafter, the present invention will be described in further detail with reference to Production Examples and Examples, but the present invention is not limited by these examples in any way.

### [Measurement Method]

### (Structure of compound)

Unless otherwise noted, the structure of a compound was evaluated by ¹H-NMR measurement using "Advance 600II spectrometer" manufactured by Bruker Inc. under the following conditions.
Frequency: 400 MHz
Solvent: d6-DMSO
Internal standard: Tetramethylsilane (TMS)
Measurement temperature: 23°C

### (Molecular weight)

The molecular weight of a compound was measured by LC-MS analysis using "Acquity UPLC/MALDI-Synapt HDMS" manufactured by Waters Inc.

### (Weight average molecular weight (Mw), number average molecular weight (Mn) and dispersibility (Mw/Mn))

The weight average molecular weight (Mw), number average molecular weight (Mn) and dispersibility (Mw/Mn) in terms of polystyrene were determined by gel permeation chromatography (GPC) analysis.
Apparatus: "Shodex GPC-101 model" manufactured by Showa Denko K.K.
Column: "KF-80M" × 3 manufactured by Showa Denko K.K.
Eluent: Tetrahydrofuran (hereinafter, also referred to as "THF")
Flow rate: 1 mL/min
Temperature: 40°C

### (Solubility)

The solubility of an obtained compound in a safe solvent (propylene glycol monomethyl ether acetate (PGMEA)) was evaluated as follows. The compound was precisely weighed in a test tube, and PGMEA was added to a predetermined concentration. Next, ultrasonic waves were applied at 23°C for 30 minutes with an ultrasonic cleaning machine, and the subsequent state of the liquid was visually observed. The concentration (% by mass) at which the compound was completely dissolved was defined as the amount of dissolution. Based on the obtained amount of dissolution, the solubility of the compound in the safe solvent was evaluated according to the following evaluation criteria.

### <Evaluation criteria>

A: amount of dissolution was 5.0% by mass or more.
B: amount of dissolution was 3.0% by mass or more and 5.0% by mass or less.
C: amount of dissolution was less than 3.0% by mass.

### [Production Example 1] Synthesis of CR-1

A four necked flask (internal capacity: 10 L) equipped with a Dimroth condenser tube, a thermometer, and a stirring blade and having a detachable bottom was prepared. To this four necked flask, 1.09 kg (7 mol) of 1,5-dimethylnaphthalene (manufactured by Mitsubishi Gas Chemical Company, Inc.), 2.1 kg (28 mol as formaldehyde) of a 40 mass% aqueous formalin solution (manufactured by Mitsubishi Gas Chemical Company, Inc.), and 0.97 mL of a 98 mass% sulfuric acid (manufactured by Kanto Chemical Co., Inc.) were added in a nitrogen stream, and the mixture was reacted for 7 hours while refluxed at 100°C at normal pressure. Subsequently, 1.8 kg of ethylbenzene (manufactured by Wako Pure Chemical Industries, Ltd., a special grade reagent) was added as a diluting solvent to the reaction solution, and the mixture was left to stand still, followed by removal of an aqueous phase as a lower phase. Neutralization and washing with water were further performed, and ethylbenzene and unreacted 1,5-dimethylnaphthalene were distilled off under reduced pressure to obtain 1.25 kg of a light brown solid dimethylnaphthalene formaldehyde resin. The molecular weight of the obtained dimethylnaphthalene formaldehyde was as follows: Mn: 562, Mw: 1168, and Mw/Mn: 2.08.

Subsequently, a four necked flask (internal capacity: 0.5 L) equipped with a Dimroth condenser tube, a thermometer, and a stirring blade was prepared. To this four necked flask, 100 g (0.51 mol) of the dimethylnaphthalene formaldehyde resin obtained as above, and 0.05 g of p-toluenesulfonic acid were added in a nitrogen stream, and the temperature was raised to 190°C at which the mixture was then heated for 2 hours, followed by stirring. Subsequently, 52.0 g (0.36 mol) of 1-naphthol was further added thereto, and the temperature was raised to 220°C at which the mixture was reacted for 2 hours. After dilution with a solvent, neutralization and washing with water were performed, and the solvent was distilled off under reduced pressure to obtain 126.1 g of a modified resin (CR-1) as a black-brown solid.

The obtained resin (CR-1) had Mn: 885, Mw: 2220, and Mw/Mn: 2.51. The solubility of the obtained resin (CR-1) in PGMEA was evaluated according to the above method for evaluating the solubility of a compound, and it was determined as "A".

### [Production Example 2] Synthesis of TOX-2

In a container (internal capacity: 100 mL) equipped with a stirrer, a condenser tube, and a burette, 1.0 g (2.8 mmol) of tetraethoxytellurium(IV) (a product from Alfa Aesar, purity: 85%) dissolved in 20 mL of tetrahydrofuran was placed, and 0.6 g (6.0 mmol) of acetylacetone dissolved in 5 mL of tetrahydrofuran was further added thereto. After refluxing for 1 hour, the solvent was distilled off under reduced pressure, thereby obtaining 0.6 g of a compound represented by the following formula (TOX-2).

The obtainment of the compound represented by formula (TOX-2) was confirmed by the ¹H-NMR chemical shifts before and after the reaction.

### [Table 1]

**Table 1**

| Ligand | Proton | Chemical shift (ppm) | |
|---|---|---|---|
| | | Before reaction | After reaction |
| Acetylacetone | -CH₃ | 2.2 | 2.3 |
| | -CH₂-(keto form) | 3.6 | Not observed |
| | -CH= (enol form) | 5.5 | 5.4 |
| | -OH (enol form) | 15.8 | Not observed |

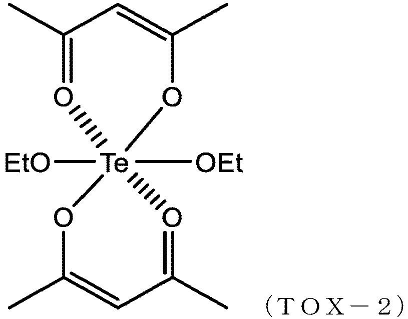

### [Production Example 3] Synthesis of TOX-3

In a container (internal capacity: 100 mL) equipped with a stirrer, a condenser tube, and a burette, 1.0 g (2.8 mmol) of tetraethoxytellurium(IV) (a product from Alfa Aesar, purity: 85%) dissolved in 20 mL of tetrahydrofuran was placed, and 0.8 g (5.6 mmol) of 2,2-dimethyl-3,5-hexanedione dissolved in 5 mL of tetrahydrofuran was further added thereto. After refluxing for 1 hour, the solvent was distilled off under reduced pressure, thereby obtaining 0.7 g of a compound represented by the following formula (TOX-3).

The obtainment of the compound represented by formula (TOX-3) was confirmed by the ¹H-NMR chemical shifts before and after the reaction.

### [Table 2]

**Table 2**

| Ligand | Proton | Chemical shift (ppm) | |
|---|---|---|---|
| | | Before reaction | After reaction |
| 2,2-Dimethyl-3,5-hexanedione | -(CH₃)₃ | 1.2 | 1.3 |
| | -CH₃ | 2.1 | 2.2 |
| | -CH₂-(keto form) | 3.7 | Not observed |
| | -CH= (enol form) | 5.7 | 5.6 |
| | -OH (enol form) | 15.8 | Not observed |

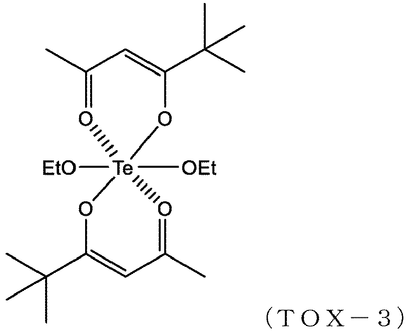

### [Production Example 4] Synthesis of TOX-4

In a container (internal capacity: 100 mL) equipped with a stirrer, a condenser tube, and a burette, 1.0 g (2.8 mmol) of tetraethoxytellurium(IV) (a product from Alfa Aesar, purity: 85%) dissolved in 20 mL of tetrahydrofuran was placed, and 0.5 g (5.8 mmol) of methacrylic acid was further added thereto. After refluxing for 1 hour, the solvent was distilled off under reduced pressure, thereby obtaining 0.5 g of a compound represented by the following formula (TOX-4).

The obtainment of the compound represented by formula (TOX-4) was confirmed by the ¹H-NMR chemical shifts before and after the reaction.

### [Table 3]

**Table 3**

| Ligand | Proton | Chemical shift (ppm) | |
|---|---|---|---|
| | | Before reaction | After reaction |
| | -CH₃ | 2.0 | 1.9 |
| Methacrylic acid | =CH₂ (1) | 5.7 | 5.6 |
| | =CH₂ (2) | 6.3 | 6.2 |
| | -COOH | 12.0 | 7.9 |

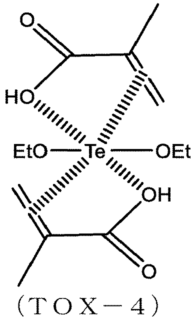

### [Examples 1 to 8 and Comparative Example 1]

Compositions for resist underlayer film formation were prepared by using the compound represented by the following formula (TOX-1), the compounds synthesized in the above Production Examples 2 to 4, the resin synthesized in Production Example 1 and the like, and by using the following components such that the compositions have the composition shown in Table 4 below.
TOX-1: Compound represented by the following formula (TOX-1)

   Te(OEt)₄ (TOX-1)
Acid generating agent: "Di-tertiary butyl diphenyliodonium nonafluoromethanesulfonate (DTDPI)" manufactured by Midori Kagaku Co., Ltd.
Acid crosslinking agent (in the table, simply designated as crosslinking agent): "NIKALAC MX270 (NIKALAC)" manufactured by Sanwa Chemical Co., Ltd.
Organic solvent: Propylene glycol monomethyl ether acetate acetate (PGMEA)
Polymerization initiator: IRGACURE 184 (manufactured by BASF SE)
Novolac: "PSM4357" manufactured by Gun Ei Chemical Industry Co., Ltd.

Next, a silicon substrate was spin coated with each of the compositions for resist underlayer film formation in Examples 1 to 8 and Comparative Example 1, and baked at 240°C for 60 seconds (Example 1, Examples 3 to 5, Example 7, Example 8 and Comparative Example 1) or at 300°C for 60 seconds (Example 2 and Example 6) to prepare an underlayer film with a film thickness of 200 nm. Then, the etching resistance was evaluated under the conditions shown below. The evaluation results are shown in Table 1.

### [Etching resistance]

The evaluation of etching resistance was carried out by the following procedures.

First, an underlayer film of novolac was prepared under the same conditions as in Example 1 except that novolac ("PSM4357" manufactured by Gun Ei Chemical Industry Co., Ltd.) was used instead of the tellurium containing compound and resin used in Example 1. Then, this underlayer film of novolac was subjected to etching under the following conditions, and the etching rate was measured. Next, each of the underlayer films of Examples and Comparative Example were subjected to etching under the following conditions in the same manner as for the underlayer film of novolac, and the etching rate was measured. Then, the etching resistance was evaluated according to the following evaluation criteria on the basis of the etching rate of the underlayer film of novolac.

### <Etching conditions>

Etching apparatus: "RIE-10NR" manufactured by Samco International, Inc.
Output: 50 W
Pressure: 20 Pa
Time: 2 min
Etching gas
Ar gas flow rate:CF₄ gas flow rate:O₂ gas flow rate = 50:5:5 (sccm)

### <Evaluation criteria>

A: The etching rate was less than -10% as compared with that of the underlayer film of novolac.
B: The etching rate was -10% or more and +5% or less as compared with that of the underlayer film of novolac.
C: The etching rate was greater than +5% as compared with that of the underlayer film of novolac.

### [Table 4]

**Table 4**

| | Composition for resist underlayer film formation | | | | | | Evaluation | |
|---|---|---|---|---|---|---|---|---|
| | Tellurium containing compound (parts by mass) | Resin (parts by mass) | Organic solvent (parts by mass) | Acid generating agent (parts by mass) | Crosslinking agent (parts by mass) | Polymerization initiator (parts by mass) | Solubility of tellurium containing compound | Etching resistance |
| Example 1 | TOX-1 (5) | CR-1 (5) | PGMEA (90) | DTDPI (0.5) | NIKALAC (0.5) | None | A | A |
| Example 2 | TOX-1 (5) | CR-1 (5) | PGMEA (90) | None | None | None | A | A |
| Example 3 | TOX-2 (5) | CR-1 (5) | PGMEA (90) | DTDPI (0.5) | NIKALAC (0.5) | None | A | A |
| Example 4 | TOX-3 (5) | CR-1 (5) | PGMEA (90) | DTDPI (0.5) | NIKALAC (0.5) | None | A | A |
| Example 5 | TOX-4 (5) | CR-1 (5) | PGMEA (90) | DTDPI (0.5) | NIKALAC (0.5) | None | A | A |
| Example 6 | TOX-2 (5) | CR-1 (5) | PGMEA (90) | None | None | None | A | A |
| Example 7 | TOX-3 (5) | CR-1 (5) | PGMEA (90) | DTDPI (0.5) | NIKALAC (0.5) | IRGACURE 184 (0.05) | A | A |
| Example 8 | TOX-4 (5) | CR-1 (5) | PGMEA (90) | DTDPI (0.5) | NIKALAC (0.5) | IRGACURE 184 (0.05) | A | A |
| Com parative Example 1 | - | CR-1 (10) | PGMEA (90) | DTDPI (0.5) | NIKALAC(0.5) | None | A | C |

### [Examples 9 to 12]

Next, a silicon substrate having a SiO₂ layer with a thickness of 300 nm on the surface thereof was coated with each of the compositions for resist underlayer film formation of Example 1 and Examples 3 to 5, and baked at 240°C for 60 seconds and further at 400°C for 120 seconds to form a resist underlayer film with a film thickness of 85 nm. This underlayer film was coated with a resist solution and baked at 110°C for 90 seconds to form a photoresist layer with a film thickness of 40 nm. Note that the resist solution used was prepared by compounding 80 parts by mass of a compound represented by the following formula (CR-1A), 20 parts by mass of hexamethoxymethylmelamine, 20 parts by mass of triphenylsulfonium trifluoromethanesulfonate, 3 parts by mass of tributylamine, and 5000 parts by mass of propylene glycol monomethyl ether.

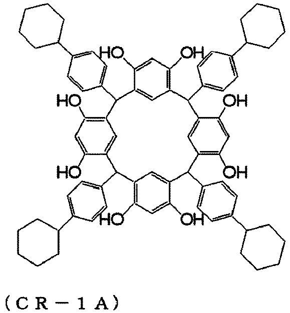

The compound represented by the formula (CR-1A) was synthesized as follows. In an autoclave equipped with an electromagnetic stirrer (made of SUS316L) that has an internal capacity of 500 mL and is capable of controlling the temperature, 74.3 g (3.71 mol) of anhydrous HF and 50.5 g (0.744 mol) of BF₃ were charged, and the contents were stirred. While keeping the liquid temperature at - 30°C, the pressure was raised to 2 MPa with carbon monoxide. Then, while maintaining the pressure at 2 MPa and the liquid temperature at -30°C, a raw material obtained by mixing 57.0 g (0.248 mol) of cyclohexylbenzene and 50.0 g of n-heptane was supplied and kept for 1 hour. Subsequently, the contents were collected, put in ice, diluted with benzene, subjected to neutralization treatment, and the obtained oil layer was analyzed by gas chromatography. When the reaction results were determined, the conversion rate of cyclohexylbenzene was 100% and the selectivity of 4-cyclohexylbenzaldehyde was 97.3%. The target component was isolated by simple distillation and analyzed by GC-MS. As a result, the target product, 4-cyclohexylbenzaldehyde (hereinafter, referred to as "CHBAL") exhibited a molecular weight of 188. That is, the above molecular weight was measured by using "GC-MS QP2010 Ultra" manufactured by Shimadzu Corporation. In addition, the chemical shift value (δ ppm, TMS standard) of ¹H-NMR in a deuterated chloroform solvent is 1.0 to 1.6 (m, 10H), 2.6 (m, 1H), 7.4 (d, 2H), 7.8 (d, 2H) and 10.0 (s, 1H).

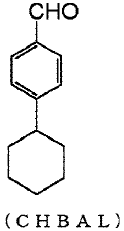

A four necked flask (1000 mL) equipped with a dropping funnel, a Dimroth condenser tube, a thermometer and a stirring blade was sufficiently dried and purged with nitrogen, and then by introducing resorcinol (22 g, 0.2 mol) manufactured by Kanto Chemical Co., Inc., the above 4-cyclohexylbenzaldehyde (46.0 g, 0.2 mol) and dehydrated ethanol (200 mL), an ethanol solution was prepared. While stirring this ethanol solution, it was heated to 85°C with a mantle heater. Then, 75 mL of concentrated hydrochloric acid (35% by mass) was added dropwise using the dropping funnel over 30 minutes, and subsequently, the resultant solution was stirred at 85°C for 3 hours. After the reaction terminated, the solution was allowed to cool to room temperature and then cooled in an ice bath. After leaving the solution to stand for 1 hour, pale yellow target crude crystals were produced, which were separated by filtration. The crude crystals were washed twice with 500 mL of methanol, filtered off, and dried under vacuum, thereby obtaining 50 g of a compound represented by the above formula (CR-1A) as a product. As a result of analysis by LC-MS, the structure of this compound exhibited a molecular weight of 1121. In addition, the chemical shift value (δ ppm, TMS standard) of ¹H-NMR in a deuterated chloroform solvent is 0.8 to 1.9 (m, 44H), 5.5, 5.6 (d, 4H), 6.0 to 6.8 (m, 24H), and 8.4, 8.5 (m, 8H). From these results, the obtained product was identified as a compound represented by the formula (CR-1A) (yield 91%).

Subsequently, the photoresist layer described above was exposed using an electron beam lithography system (manufactured by ELIONIX INC.; ELS-7500, 50 keV), baked (PEB) at 110°C for 90 seconds, and developed for 60 seconds in a 2.38 mass% tetramethylammonium hydroxide (TMAH) aqueous solution to obtain a negative type resist pattern.

### [Comparative Example 2]

The same operations as in Example 9 were performed except that no resist underlayer film was formed such that a photoresist layer was formed directly on a SiO₂ substrate to obtain a negative type resist pattern.

### [Evaluation]

Concerning each of Examples and Comparative Example, the shapes of the obtained 45 nm L/S (1:1) and 80 nm L/S (1:1) resist patterns were observed using an electron microscope (manufactured by Hitachi, Ltd.; S-4800). The shapes of the resist patterns after development were evaluated as good when having "good" rectangularity without pattern collapse, and as "poor" if this was not the case. The smallest line width having good rectangularity without pattern collapse as a result of this observation was used as an index for resolution evaluation. Furthermore, the smallest electron beam energy quantity capable of lithographing good pattern shapes was used as an index for sensitivity evaluation. The results are shown in Table 5.

**[Table 5]**

| | Composition for underlayer film formation (parts by mass) | Resolution (nmL/S) | Sensitivity (µC/cm²) | Resist pattern shape after development |
|---|---|---|---|---|
| Example 9 | Composition described in Example 1 | 45 | 10 | Good |
| Example 10 | Composition described in Example 3 | 45 | 10 | Good |
| Example 11 | Composition described in Example 4 | 45 | 10 | Good |
| Example 12 | Composition described in Example 5 | 45 | 10 | Good |
| Comparative Example 2 | None | 80 | 32 | Poor |

As is evident from Table 5, the resist underlayer films of Examples 9 to 12 using the compositions for resist underlayer film formation of the present embodiment were confirmed to be significantly superior in both resolution and sensitivity to Comparative Example 2. Also, since the resist pattern shapes after development have good rectangularity without pattern collapse, it was confirmed that the pattern does not flag during heating and is excellent in heat resistance. Furthermore, from the difference in the resist pattern shape after development, it was indicated that the compositions for resist underlayer film formation in Examples 9 to 12 are excellent in the embedding properties to a substrate having difference in level and film flatness, and have good adhesiveness to a resist material.

### [Example 13]

A silicon substrate having a SiO₂ layer with a thickness of 300 nm was coated with the composition for resist underlayer film formation obtained in Example 1, and baked at 240°C for 60 seconds and further at 400°C for 120 seconds to form a resist underlayer film with a film thickness of 90 nm. This resist underlayer film was coated with a silicon containing intermediate layer material and baked at 200°C for 60 seconds to form a resist intermediate layer film with a film thickness of 35 nm. This resist intermediate layer film was further coated with the resist solution used in the above Example 9 and baked at 130°C for 60 seconds to form a photoresist layer with a film thickness of 150 nm. Note that the silicon containing intermediate layer material used was the silicon atom containing polymer described in <Production Example 1> of Japanese Patent Application Laid-Open No. 2007-226170. Subsequently, the photoresist layer was mask exposed using an electron beam lithography system (manufactured by ELIONIX INC.; ELS-7500, 50 keV), baked (PEB) at 115°C for 90 seconds, and developed for 60 seconds in a 2.38 mass% tetramethylammonium hydroxide (TMAH) aqueous solution to obtain a 45 nm L/S (1:1) negative type resist pattern. Then, the silicon containing intermediate layer film (SOG) was dry etched with the obtained resist pattern as a mask using "RIE-10NR" manufactured by Samco International, Inc. Subsequently, dry etching of the resist underlayer film with the obtained silicon containing intermediate layer film pattern as a mask and dry etching of the SiO₂ film with the obtained resist underlayer film pattern as a mask were performed in order.

Respective etching conditions are as shown below.

### (Conditions for etching of resist intermediate layer film with resist pattern)

Output: 50 W
Pressure: 20 Pa
Time: 1 min
Etching gas
Ar gas flow rate:CF₄ gas flow rate:O₂ gas flow rate = 50:8:2 (sccm)

### (Conditions for etching of resist underlayer film with resist intermediate layer film pattern)

Output: 50 W
Pressure: 20 Pa
Time: 2 min
Etching gas
Ar gas flow rate:CF₄ gas flow rate:O₂ gas flow rate = 50:5:5 (sccm)

### (Conditions for etching of SiO₂ film with resist underlayer film pattern)

Output: 50 W
Pressure: 20 Pa
Time: 2 min
Etching gas
Ar gas flow rate:C₅F₁₂ gas flow rate:C₂F₆ gas flow rate:O₂ gas flow rate
   = 50:4:3:1 (sccm)

### [Evaluation]

The pattern cross section (the shape of the SiO₂ film after etching) of Example 13 obtained as described above was observed using an electron microscope "S-4800" manufactured by Hitachi, Ltd. As a result, it was confirmed that the shape of the SiO₂ film after etching in a multilayer resist process is a rectangular shape and is good without defects.

As long as the requirements of the present invention are met, compounds other than the compounds described in Examples also exhibit the same effects.

As described above, the composition of the present embodiment is applicable to a wet process, is excellent in heat resistance, etching resistance, embedding properties to a substrate having difference in level, and film flatness, and thus is suitably used as a resist underlayer film.

## Claims

1. A composition for resist underlayer film formation, comprising a compound represented by the following formula (1):
[LₓTe(OR¹)_{y}] (1)
wherein L is a ligand other than OR¹; R¹ is any of a hydrogen atom, a substituted or unsubstituted, linear alkyl group having 1 to 20 carbon atoms or branched or cyclic alkyl group having 3 to 20 carbon atoms, a substituted or unsubstituted aryl group having 6 to 20 carbon atoms, a substituted or unsubstituted alkenyl group having 2 to 20 carbon atoms and a substituted or unsubstituted alkynyl group having 2 to 20 carbon atoms; x is an integer of 0 to 6; y is an integer of 0 to 6; a total of x and y is 1 to 6; when x is 2 or more, a plurality of L may be the same or different; and when y is 2 or more, a plurality of R¹ may be the same or different.

2. The composition for resist underlayer film formation according to claim 1, wherein, in the compound represented by the above formula (1), x is an integer of 1 to 6.

3. The composition for resist underlayer film formation according to claim 1 or 2, wherein, in the compound represented by the above formula (1), y is an integer of 1 to 6.

4. The composition for resist underlayer film formation according to any one of claims 1 to 3, wherein, in the compound represented by the above formula (1), R¹ is a substituted or unsubstituted, linear alkyl group having 1 to 6 carbon atoms or branched or cyclic alkyl group having 3 to 6 carbon atoms.

5. The composition for resist underlayer film formation according to any one of claims 1 to 4, wherein, in the compound represented by the above formula (1), L is a bi- or higher-dentate ligand.

6. The composition for resist underlayer film formation according to any one of claims 1 to 5, wherein, in the compound represented by the above formula (1), L is any of acetylacetonato, 2,2-dimethyl-3,5-hexanedione, ethylenediamine, diethylenetriamine and methacrylic acid.

7. The composition for resist underlayer film formation according to any one of claims 1 to 6, further comprising a solvent.

8. The composition for resist underlayer film formation according to any one of claims 1 to 7, further comprising an acid generating agent.

9. The composition for resist underlayer film formation according to any one of claims 1 to 8, further comprising an acid crosslinking agent.

10. The composition for resist underlayer film formation according to any one of claims 1 to 9, further comprising an acid diffusion controlling agent.

11. The composition for resist underlayer film formation according to any one of claims 1 to 10, further comprising a polymerization initiator.

12. A method for forming a pattern, comprising the steps of:
forming a resist underlayer film on a substrate using the composition for resist underlayer film formation according to any one of claims 1 to 11;
forming at least one photoresist layer on the resist underlayer film; and
irradiating a predetermined region of the photoresist layer with radiation for development.

13. A method for forming a pattern, comprising the steps of:
forming a resist underlayer film on a substrate using the composition for resist underlayer film formation according to any one of claims 1 to 11;
forming a resist intermediate layer film on the resist underlayer film using a resist intermediate layer film material;
forming at least one photoresist layer on the resist intermediate layer film;
irradiating a predetermined region of the photoresist layer with radiation for development, thereby forming a resist pattern;
etching the resist intermediate layer film with the resist pattern as an etching mask, thereby forming an intermediate layer film pattern;
etching the resist underlayer film with the intermediate layer film pattern as an etching mask, thereby forming an underlayer film pattern; and
etching the substrate with the underlayer film pattern as an etching mask, thereby forming a pattern on the substrate.
